# FASCICULE DE BREVET EUROPEEN

(11) **EP 2 115 768 B1**
(45) Date de publication et mention de la délivrance du brevet: **14.11.2012**
(21) Numéro de dépôt: 07847300.6
(22) Date de dépôt: 23.11.2007
(51) Int. Cl.: H01L 21/02, H01L 21/20

(54) **PROCEDE DE COLLAGE DE DEUX SUBSTRATS**
VERFAHREN ZUM BONDEN ZWEIER SUBSTRATE
METHOD OF BONDING TWO SUBSTRATES

(30) Priorité: 16.02.2007 FR 0753318
(43) Date de publication de la demande: 11.11.2009
(73) Titulaire: Soitec, 38190 Bernin (FR)
(72) Inventeur: KERDILES, Sébastien, F-38330 Saint-Ismier (FR); MICHEL, Willy, F-34400 Lunel (FR); SCHWARZENBACH, Walter, F-38330 Saint Nazaire Les Eymes (FR); DELPRAT, Daniel, F-38920 Crolles (FR); BEN MOHAMED, Nadia, F-38130 Echirolles (FR)
(74) Mandataire: Collin, Jérôme
(86) Numéro de dépôt international: PCT/EP2007/062750
(87) Numéro de publication internationale: WO 2008/107029

(56) Documents cités:
- EP-A- 0 969 500
- FR-A1- 2 868 599
- FR-A1- 2 884 966
- US-A1- 2004 262 686

## Description

La présente invention est relative à la réalisation de structures composites pour l'électronique, l'optique ou la microélectronique.

Plus précisément, l'invention concerne un procédé de collage de deux substrats entre eux.

L'invention concerne également un procédé de formation d'une structure comprenant une couche en matériau semi-conducteur prélevée à partir d'un substrat donneur, ledit substrat donneur ayant lui-même été constitué par collage de deux substrats.

Pour coller deux substrats entre eux, on procède typiquement à la mise en contact d'un premier substrat avec un second substrat de manière à réaliser un collage par adhésion moléculaire des substrats entre eux.

Une application d'un tel collage est celle qui est faite dans le cadre de la réalisation de structures du type « semi-conducteur sur isolant » (en anglais, *« Semiconductor On Insulator,* » (SeOI)), et en particulier les structures du type « silicium sur isolant » SOI (en anglais, « Silicon On Insulator » (SOI)).

Dans ce cadre d'application, l'un au moins des substrats à coller présente une couche d'oxyde en surface ; à titre d'exemple, on réalise typiquement un collage Si/SiO₂ ou encore un collage SiO₂/SiO₂ afin de former une structure SOI.

Le collage par adhésion moléculaire est une technique permettant de faire adhérer l'un à l'autre deux substrats présentant des surfaces parfaitement planes (« poli-miroir ») et cela sans application d'adhésif (de type colle, glue, etc.).

Les surfaces en question sont en général celles de substrats en matériau électriquement isolant (quartz, verre, par exemple) ou en matériau semi-conducteur (Si, GaAs, SiC, Ge, par exemple).

Le collage est typiquement initié par application locale d'une légère pression sur un ou les deux substrats mis en contact.

Une onde de collage se propage ensuite sur toute l'étendue des substrats en quelques secondes, pour rapprocher les deux substrats à l'échelle atomique.

L'énergie de collage obtenue à température ambiante est généralement assez faible par rapport à celle observée entre deux solides liés de façon covalente, ionique ou métallique.

Afin d'obtenir un collage satisfaisant de deux substrats entre eux, on réalise habituellement avant collage une préparation de l'une et/ou l'autre des surfaces à coller. Il s'agit là d'augmenter la tenue mécanique et/ou d'accroître la qualité de l'interface de collage.

Une telle préparation implique typiquement un traitement chimique - appelé nettoyage - des surfaces des substrats à coller.

Le nettoyage vise notamment à procurer une ou plusieurs des propriétés suivantes pour les surfaces à coller :
- l'absence de particules ;
- l'absence d'hydrocarbures ;
- l'absence de contaminants métalliques ;
- une faible rugosité de surface, typiquement inférieure à 5 Å RMS ;
- une forte hydrophilie, c'est-à-dire une densité importante de liaisons silanols (liaisons Si-OH) terminant les surfaces à coller.

A titre d'exemples, de nettoyage avant collage, on peut mentionner :
- le nettoyage de type RCA, tel que décrit dans le document FR 1868 599, à savoir la combinaison d'un bain SC1 (en anglais, *« Standard Clean 1»*) comprenant de l'hydroxyde d'ammonium (NH₄OH) du peroxyde d'hydrogène (H₂O₂) et de l'eau (H₂O) adapté au retrait des particules et des hydrocarbures et d'un bain SC2 (en anglais, *« Standard Clean* 2 ») comprenant de l'acide chlorhydrique (HCl), du peroxyde d'hydrogène (H₂O₂) et de l'eau (H₂O) adapté au retrait des contaminants métalliques ;
- le nettoyage avec une solution ozonée (O₃) adapté au retrait des contaminants organiques ;
- le nettoyage avec une solution contenant un mélange d'acide sulfurique et d'eau oxygénée (en anglais, *« Sulfuric Peroxide Mixture, »* (SPM)).

Le contrôle des différents paramètres de nettoyage (notamment la température des bains) permet de prévenir l'apparition de certains défauts au niveau de l'interface de collage de la structure collée.

Ces défauts occasionnés sont par exemple des cloques au niveau de l'interface de collage entre les deux substrats.

Un autre type de défaut peut par ailleurs être observé dans le cas où on opère un transfert d'une couche mince du substrat donneur vers un substrat receveur, les procédés du type Smart Cut™ étant un exemple avantageux d'un tel transfert (concernant les procédés du type Smart Cut™, l'homme du métier pourra par exemple se référer à « Silicon Wafer bonding technology for VLSI and MEMS applications, » S.S. lyer and A.J. Auberton-Hervé, IEE, 2002). Dans un tel cas, on peut en effet observer des trous dans la couche mince transférée, localisés dans la région périphérique du substrat receveur. Ces zones non transférées, de diamètre compris entre 50µm et 2mm, localisées entre 0,5 à 5mm du bord de la structure sont appelés « picots » (ou encore « *edge voids* », en anglais).

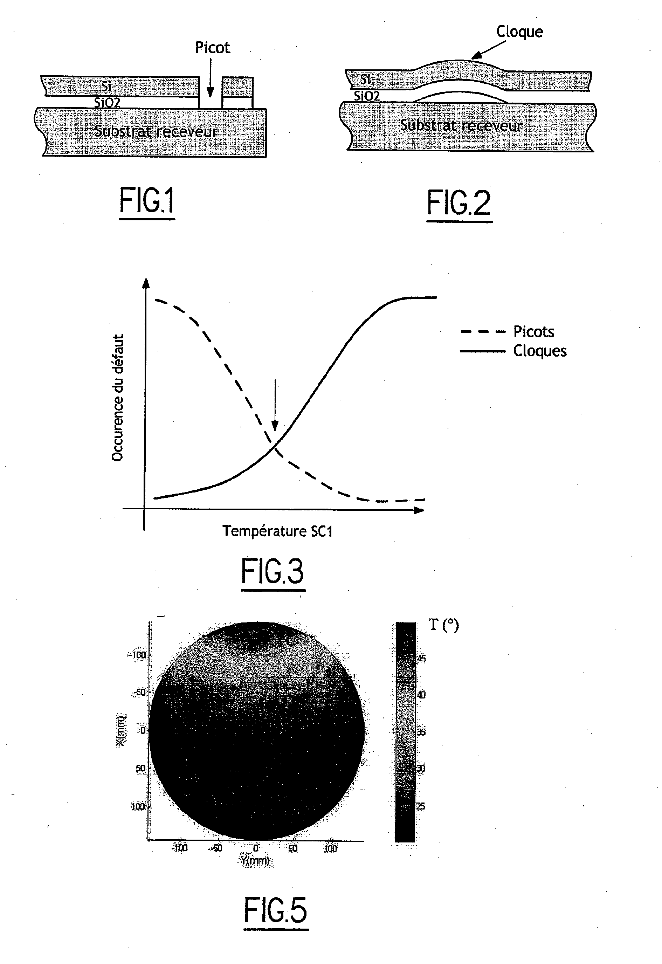

La figure 1 montre, schématiquement, une vue en coupe d'un SOI avec un picot. Les couches transférées sur le substrat receveur présentent un trou de diamètre typiquement compris entre 50µm et 2mm, situé à 1-5mm du bord de la structure.

Les picots sont ainsi des défauts macroscopiques liés à un mauvais collage en bord des substrats. Il s'agit de défauts graves et généralement rédhibitoires. En effet, en l'absence de couche mince servant de couche active pour la formation de composants électroniques à la localisation d'un picot, aucun composant ne peut être fabriqué à cette localisation. Etant donné la taille des picots, un composant électronique comprenant au moins un picot est nécessairement défectueux.

Les défauts de type « cloques », correspondent à un décollement local entre la couche mince transférée et le substrat receveur. Par exemple, dans le cas d'un SOI obtenu par le procédé Smart Cut™, le collage d'un substrat receveur Si sur un substrat donneur oxydé et implanté peut conduire à l'observation de cloques sur la structure obtenue après transfert. Ces cloques résultent du décollement local entre le silicium receveur et l'oxyde de la couche mince transférée, comme cela est schématisé sur la figure 2.

Ce décollement local est favorisé par d'éventuelles particules, traces d'hydrocarbures, ou encore des irrégularités de surface (micro-rugosité localement plus élevée) à la surface d'un et/ou des deux substrats mis en contact.

Dans le cas où le collage est réalisé en vue d'un transfert de type Smart Cut™ (dans un souci de simplification on se réfèrera dans la suite de ce texte à ce cas par « formation d'un SOI »), les cloques créées au niveau de l'interface de collage entre le substrat donneur et le substrat receveur peuvent se dilater lors du recuit de détachement qu'implique un tel transfert, ceci peut endommager la couche utile de la structure finale obtenue à l'issue du transfert.

Comme cela est schématisé sur la figure 2, dans le cadre de la formation d'un SOI, les cloques peuvent être localisées au centre comme en périphérie de la structure.

Les cloques sont ainsi des défauts macroscopiques, circulaires de diamètre typiquement compris entre 0,1mm et 3mm, à l'issue d'un transfert de couche mince.

Les cloques sont dans un tel cas des défauts rédhibitoires pour un SOI.

Il est connu que les défauts de type cloques et picots sont liés au collage et à la préparation de la surface.

Plus précisément, il a été observé que certaines conditions de nettoyage avant collage conduisaient à des collages dans lesquels :
- on prévient l'apparition de défauts de type cloques au niveau de l'interface de collage, en utilisant notamment un bain SC1 de faible concentration et surtout à faible température (typiquement de l'ordre de 65°C au plus),
- on prévient l'apparition de défauts de type picots au niveau de l'interface de collage après transfert, en utilisant notamment un bain SC1 à haute température (typiquement de l'ordre de 70°C au moins).

Les conditions, mentionnées ci-dessus, permettant d'éviter les défauts de type cloques et picots sont ainsi antagonistes.

En pratique, l'étape de préparation par nettoyage implique donc de trouver un compromis (notamment en ce qui concerne la température à laquelle on effectue le nettoyage avant collage) afin d'obtenir une interface de collage au niveau de laquelle on observera plus ou moins de cloques et de picots.

### RESUME DE L'INVENTION

La présente invention se propose de pallier aux problèmes susmentionnés, et notamment de supprimer la nécessité d'un compromis dans la définition des conditions (température en particulier) de nettoyage, pour prévoir l'apparition de défauts de type picots et l'apparition de défauts de type cloques au niveau de l'interface de collage entre deux substrats.

A cet effet, l'invention propose selon un premier aspect un procédé de collage de deux substrats entre eux au cours duquel on procède à la mise en contact des surfaces desdits substrats, comprenant au moins une étape de nettoyage de la surface de l'un et/ou l'autre des substrats à coller avant la mise en contact de leurs surfaces,
- le collage étant en outre précédé d'un chauffage d'au moins un substrat à colier, ledit chauffage étant initié avant la mise en contact des surface des substrats et prolongé au moins jusqu'à leur mise en contact, où
- l'étape de nettoyage est réalisée de manière à ce que chaque surface nettoyée soit peu rugosifiée, c'est à dire avec une augmentation de la rugosité comprise entre 0 et 20 % l'étape de nettoyage de l'un et/ou l'autre des substrats à coller implique une gravure d'une épaisseur inférieur à 15 Angströms ;
- caractérisé en ce que, le chauffage est appliqué localement au niveau d'une zone périphérique d'au moins un des deux substrats à coller, ou appliqué de manière uniforme sur l'étendue d'au moins un des deux substrats à coller et est conduit à une température comprise entre 35°C et 90°C, typiquement entre 45°C et 70°C ;

Des aspects préférés, mais non limitatifs de ce procédé sont les suivants :
- le chauffage se termine au plus tard à la fin de la propagation de l'onde
   de collage entre les deux substrats ;
- l'étape de nettoyage est mise en oeuvre au moyen d'un bain à une température inférieure à 65°C ;
- l'étape de nettoyage est mise en oeuvre au moyen d'un bain à base de NH₄OH, H₂O₂, H₂O, ou d'un bain à base de NH₄OH, H₂O₂, H₂O suivi d'un bain à base de HCl, H₂O₂, H₂O, ou en utilisant un bain ozoné suivi d'un bain à base de NH₄OH, H₂O₂, H₂O suivi d'un bain à base de HCl, H₂O₂, H₂O, ou en utilisant un bain d'acide sulfurique et d'eau oxygénée suivi d'un bain à base de NH₄OH, H₂O₂, H₂O, suivi d'un bain à base de HCl, H₂O₂, H₂O ;
- l'étape de nettoyage est mise en oeuvre en utilisant de l'ozone sec suivi du bain à base de NH₄OH, H₂O₂, H₂O, suivi d'un bain à base de HCl, H₂O₂, H₂O ;
- le procédé peut comprendre une étape d'activation par plasma mise en oeuvre après l'étape de nettoyage et avant l'étape de collage de l'un et/ou l'autre des substrats à coller ;
- le plasma est à base d'O₂ et/ou de N₂ ;
- le plasma conduit à une diminution de la rugosité de l'un et/ou l'autre desdits substrats à coller ;
- la température du bain à base de NH₄OH, H₂O₂, H₂O est inférieure à 65°C ;
- le bain à base de NH₄OH, H₂O₂, H₂O :
   - a un dosage en pourcentage massique en NH₄OH/H₂O₂ typiquement compris entre 1/2 et 6/6 et préférentiellement entre 1/2 et 3/4,
   - est à une température comprise entre 5°C et 60°C, préférentiellement entre 40°C et 55°C,
   - est appliqué pendant quelques minutes, préférentiellement trois minutes ;
- le bain à base de HCl, H₂O₂, H₂O :
   - a un dosage en pourcentage massique de HCl compris entre 0,3% et 2%,
   - a un dosage en pourcentage massique de H₂O₂ compris entre 0,3% et 2%,
   - est à une température de 30°C,
   - est appliqué pendant quelques minutes, préférentiellement trois minutes ;
- en outre, le chauffage est obtenu par conduction thermique ou par rayonnement.

Un autre objet de l'invention concerne un procédé de formation d'une structure comprenant une couche mince en matériau semi-conducteur transférée d'un substrat donneur sur un second substrat, le procédé comprenant les étapes suivantes :
- co-implantation de deux espèces atomiques dans le substrat donneur de manière à créer une zone de fragilisation délimitant la couche mince à transférer, chacune des espèces présentant une concentration maximale à une profondeur dite « pic » ,
- nettoyage de la surface de l'un et/ou l'autre desdits substrats avant la mise en contact intime des surfaces des substrats à coller,
- mise en contact du second substrat avec le substrat donneur de manière à réaliser un collage desdits substrats entre eux,
- transfert d'une partie du substrat donneur vers le second substrat de manière à former ladite couche mince sur le second substrat,
ledit procédé étant caractérisé en ce que les deux espèces atomiques sont implantées de telle sorte que leurs pics présentent un décalage inférieur à 200 Å dans l'épaisseur du substrat donneur, et en ce que le collage est réalisé conformément au procédé de collage décrit plus haut.

De préférence, les pics des deux espèces atomiques, qui sont avantageusement de l'hydrogène et de l'hélium, sont alignés à la même profondeur du substrat donneur.

Selon un mode particulier de réalisation, l'énergie d'implantation de l'hydrogène dans un substrat donneur de silicium recouvert d'une couche d'oxyde de 1450 Å est choisie à 32 keV de telle sorte que le pic d'implantation de l'hydrogène soit situé à une profondeur de 2450 Å dans le substrat donneur et l'énergie d'implantation de l'hélium est comprise entre 47 et 50 keV, de préférence 49 keV.

### PRESENTATION DES FIGURES

D'autres caractéristiques et avantages de l'invention ressortiront encore de la description qui suit laquelle est purement illustrative et non limitative et doit être lue en regard des dessins annexés sur lesquels outre les figures 1 et 2 déjà discutées :
- la figure 3 illustre l'occurrence des cloques (traits pleins) et des picots (traits pointillés) en fonction de la température du bain SC1 ;
- les figures 4a et 4b illustrent la propagation de l'onde de collage selon que le collage est initié à partir du centre de la structure (figure 4a) ou du bord de la structure (figure 4b), la région périphérique dans laquelle sont attendus les éventuels picots est représentée par des points ;
- la figure 5 illustre une cartographie de la température sur un substrat de silicium de diamètre égal à 300mm, après quinze secondes de chauffage local dans la partie haute du substrat dans le cas où les picots sont attendus dans cette partie en raison d'un collage initié dans la partie basse de ce substrat ;
- la figure 6 illustre des pics d'hélium décalés et alignés sur le pic d'hydrogène ;
- la figure 7 représente la distribution des défauts de type « zone dense » selon trois options de procédé comparées ;
- les figures 8A à 8C illustrent la présence d'une zone dense par une superposition des cartographies de défauts observées sur typiquement 25 plaques superposées dans différentes conditions d'implantation et de nettoyage.

### DESCRIPTION DE L'INVENTION

Comme déjà mentionné, l'invention concerne un procédé de collage de deux substrats entre eux.

L'invention vise notamment à s'affranchir du compromis lié à l'apparition de cloques et de picots et mentionné ci-dessus.

La Demanderesse est partie du constat que l'occurrence de défauts de type cloques peut être diminuée en modifiant les paramètres des bains utilisés pour le nettoyage des surfaces à coller.

Cependant, comme cela a déjà été mentionné, les conditions de nettoyage favorisant la diminution des cloques tendent à augmenter l'occurrence de picots dans le cas d'un transfert.

La pratique actuellement connue implique donc généralement de ménager un compromis dans la définition des conditions de nettoyage (en particulier), en fonction de la température et de la quantité de cloques et de picots que l'on est prêt à avoir.

La figure 3 illustre schématiquement le principe d'un tel compromis, l'occurrence des cloques (traits pleins) et des picots (traits pointillés) est représentée en fonction de la température du bain SC1.

Ainsi :
- un nettoyage au moyen d'un bain SC1 à haute température entraînant une gravure ou une rugosification de la surface des substrats nettoyés, permet d'éviter les picots mais favorise l'apparition de cloques,
- un nettoyage au moyen d'un bain SC1 à basse température, typiquement inférieure à 65°C, entraînant une faible rugosification et une très légère gravure (enlèvement inférieur à 15 Angströms, typiquement 5-10 Å) de la surface des substrats nettoyés permet d'éviter les cloques mais favorise l'apparition de picots.

Il est à noter que les spécifications en termes d'absence de picots sont de plus en plus sévères.

La Demanderesse, propose de choisir lors du nettoyage des surfaces des substrats à coller des conditions visant à prévenir l'apparition de cloques en s'affranchissant lors de ce nettoyage de préoccupations liées à la possible apparition de picots.

De telles conditions de nettoyage doivent ainsi produire des surfaces nettoyées qui présentent une rugosité et une épaisseur « quasiment » inchangées par le nettoyage du fait de la faible gravure.

On rappelle que la faible dégradation de l'un et/ou l'autre des substrats à coller est typiquement obtenue au moyen d'un bain SC1 à faible température, typiquement inférieure à 65°C.

De manière plus générale, on pourra mettre en oeuvre tout type de nettoyage permettant d'assurer que l'étape de nettoyage est réalisée de manière à ce que chaque surface nettoyée présente à l'issue du nettoyage une rugosité inchangée par nettoyage ou dans le pire des cas augmentée de 20% par rapport à sa valeur avant l'étape de nettoyage. A cet effet, la rugosité est mesurée par AFM (microscope à force atomique) sur des surfaces de 10x10µm², La rugosification peut alors être évaluée en comparant la rugosité après et avant le nettoyage.

En outre, la rugosification par nettoyage est associée à une gravure engendrée par celui-ci. Il convient donc de mettre en oeuvre tout type de nettoyage conduisant à une gravure inférieure à 15 Angströms, typiquement 5-10 Å).

Le fait de ne pas dégrader les surfaces de l'un et/ou l'autre des substrats à coller a pour effet de limiter l'apparition des cloques.

L'apparition des picots est prévenue par la suite par un contrôle du collage (contrôle de la vitesse de propagation de l'onde de collage) des substrats au moyen d'un chauffage de l'un et/ou l'autre des substrats à coller.

La Demanderesse a développé une méthode permettant de réduire l'occurrence de picots, fondée sur le contrôle de la vitesse de propagation de l'onde de collage par chauffage de l'un et/ou l'autre des substrats à coller.

En effet, il apparaît que c'est d'une part le caractère hydrophile et d'autre part la faible rugosité des surfaces des substrats à coller qui impactent la vitesse de propagation de l'onde de collage.

Il apparaît alors que le contrôle de l'apparition des cloques et des picots s'effectue de manière indépendante.

Ainsi, dans le cadre de l'invention, on se propose, d'une part, de procéder au nettoyage de l'un et/ou l'autre des substrats à coller de manière à ce qu'à l'issue du nettoyage, les surfaces des substrats à coller et qui ont été nettoyées soient peu rugosifiées (condition favorisant la prévention de l'apparition de cloques).

On précise que le terme « peu rugosifiée » traduit une augmentation de la rugosité qui est limitée. Plus précisément ceci correspond typiquement à une augmentation de la rugosité de la surface nettoyée qui est comprise entre 0 et 20%.

Pour obtenir une surface peu rugosifiée, on pourra mettre en oeuvre pour le nettoyage une gravure d'une épaisseur inférieure à 15 Angströms.

On pourra également mettre en oeuvre un nettoyage comprenant plusieurs étapes. Dans tous les cas de figure, à l'issue du nettoyage chaque surface nettoyée a été « peu rugosifiée ».

D'autre part avant collage, on se propose de procéder à un chauffage d'au moins un substrat à coller débutant avant la mise en contact des surfaces des substrats et au moins prolongé jusqu'à leur mise en contact effective.

On note que le chauffage se termine au plus tard à la fin de la propagation de l'onde de collage entre les deux substrats.

On précise que le chauffage n'est pas nécessairement appliqué à toute la surface de l'un et/ou l'autre des substrats mais peut être limité à une région spécifique de ceux-ci. Le chauffage peut ainsi être avantageusement restreint à une surface limitée du substrat et en particulier à la région périphérique susceptible de receler des défauts de type picots.

Le nettoyage de l'un et/ou l'autre des substrats à coller peut être mis en oeuvre en combinant un ou plusieurs bains.

Les bains utilisés lors de l'étape de nettoyage conduisent à une augmentation de la rugosité des surfaces de l'un et/ou l'autre des substrats à coller comprise entre 0 et 20% et à une gravure d'épaisseur inférieure à 15 Angströms.

Un nettoyage conduisant à de tels résultats est un nettoyage pratiqué à une température inférieure à 65°C.

De manière préférée, on applique un nettoyage comprenant un bain SC1 (mélange à base de NH₄OH, H₂O₂, H₂O).

Le bain SC1 peut notamment être pratiqué à une température comprise entre 5°C et 60°C (typiquement 40°C-55°C), pendant quelques minutes (typiquement trois minutes), avec des concentrations assez faibles.

La concentration en NH₄OH / H₂O₂ (exprimée en pourcentage massique) du bain SC1 est typiquement comprise entre 1/2 et 6/6. Ces dosages en pourcentage massique sont préférentiellement égaux à 1/2 ou 3/4.

Un tel nettoyage utilisant un bain SC1 conduit typiquement à une gravure d'environ 5-15 Angströms sur un oxyde thermique fragilisé par l'implantation ionique nécessaire pour la formation d'un tel SOI.

De manière avantageuse, le bain SC1 peut être précédé d'un bain ozoné, d'un SPM (mélange à base de H₂SO₄/H₂O₂) ou encore d'un nettoyage à base d'ozone sec (atmosphère UV/O₃) pour notamment retirer les contaminations organiques.

Le bain SC1 peut aussi être avantageusement suivi d'un bain SC2 pratiqué à basse température (typiquement 30°C), de faible concentration (exprimée en pourcentage massique) typiquement 0,3 - 2% pour HCl et 0,3 - 2% pour H₂O₂ (le reste est de l'eau) pendant une durée égale à trois minutes environ.

L'utilisation d'un tel SC2 permet d'enlever une très grande partie des contaminations métalliques sans dégrader l'hydrophilie des substrats à coller favorisant la propagation de l'onde de collage lorsque celui-ci est initié.

Par ailleurs, l'un et/ou l'autre des deux substrats à coller ainsi nettoyés peuvent également subir un traitement d'activation par plasma, préférentiellement un plasma d'O₂ et/ou de N₂.

Il est à noter que l'étape d'activation par plasma peut également être vue comme une étape de nettoyage à sec à caractère lissant et correspond ainsi à une étape supplémentaire du nettoyage. Son utilisation conduit à une amélioration de l'état de surface de l'un et/ou l'autre desdits substrats à coller.

L'activation par plasma étant vue comme une étape de nettoyage, il apparaît par conséquent que « le nettoyage » est une succession d'étapes. D'après l'invention c'est l'ensemble des étapes de nettoyage qui doit satisfaire les contraintes de rugosité des surfaces à coller.

Il est à noter que de manière préférée, ce traitement d'activation par plasma est pratiqué entre le nettoyage et le collage proprement dit, mais peut aussi être pratiqué avant le bain SC1 permettant de retirer les contaminations organiques.

Lors du chauffage de l'un et/ou l'autre des substrats à coller, la gamme de température qui permet d'éliminer les picots s'étend de 35°C à 90°C, typiquement 45°C-70°C.

Il est à noter que cette gamme de température résulte du fait qu'il convient de ne pas trop élever la température au risque de diminuer l'énergie de collage.

En effet, si les substrats sont collés à une température trop élevée, le collage ne sera pas efficace. Le collage peut même dans certains cas se révéler impossible.

En effet, le collage est en pratique effectué sans application de colle ou autre glue. C'est l'eau adsorbée sur chacune des surfaces (quelques monocouches d'eau) mises en contact qui sert de colle et assure l'adhésion des deux substrats en contact par l'intermédiaire de forces de Van der Waals.

Ainsi, si les substrats sont chauffés à une température trop élevée, une trop grande partie de l'eau adsorbée (voire la totalité) est évaporée, ce qui rend le collage impossible : l'onde de collage est dans l'impossibilité de se propager correctement sur la surface de l'un et/ou l'autre des substrats à coller.

Il convient donc d'utiliser la plus basse des températures pour le chauffage permettant la disparition des picots, de manière à ne pas faire chuter l'énergie de collage, ce qui ne manquerait pas de faire apparaître d'autres défauts (par exemple des cloques après transfert de la couche mince).

De manière avantageuse, il n'est pas utile de chauffer toute la surface de l'un et/ou l'autre des deux substrats à coller. Il est possible de n'en chauffer qu'un.

En outre, il est également possible de ne chauffer que la zone où peuvent apparaître les picots.

Par exemple, si le collage des deux substrats (de forme circulaire) est initié à partir du bord, il est possible de ne chauffer que le bord diamétralement opposé à ce point. Ainsi, la zone critique d'apparition des picots est chauffée sans impacter le reste du collage en favorisant la propagation de l'onde de collage sur le reste de la surface des substrats à coller.

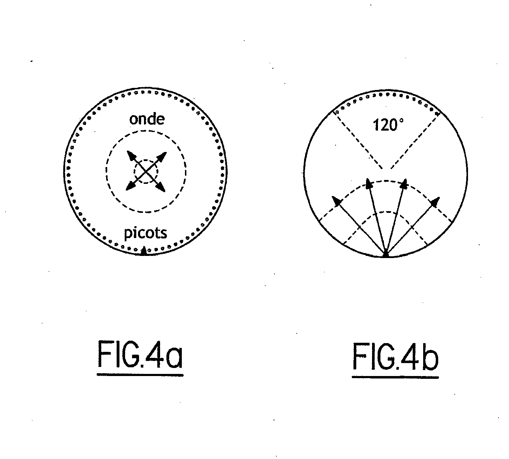

Les figures 4a et 4b illustrent la propagation de l'onde de collage selon si le collage des deux substrats est initié à partir du centre (cf. figure 5a) de la surface ou à partir du bord (cf. figure 5b).

Le chauffage local ou sur la totalité d'un ou des substrats peut être réalisé par exemple par conduction thermique (par exemple par contact avec un support qui transmet sa chaleur) ou encore par rayonnement (par exemple une lampe halogène éclairant la totalité ou une partie du ou des substrats à chauffer).

En particulier, la zone où peuvent apparaître les picots doit rester à la température désirée jusqu'à ce que les surfaces soient collées dans cette zone.

La durée du chauffage dépend fortement du dispositif utilisé pour élever puis contrôler la température de la zone chauffée.

Par exemple, à l'aide d'une lampe halogène délivrant une puissance de 500 Watts, la durée typique de chauffage est comprise entre 15 secondes et 90 secondes (cette gamme de durées dépend fortement de la distance entre les substrats et la lampe).

A l'issue par exemple d'un chauffage d'une durée de 15 secondes, dans le cas d'un collage initié au bord du substrat, le bord opposé est préférentiellement le point le plus chaud, présentant une température d'environ 50°C.

A l'issue, par exemple, d'un chauffage d'une durée de 50 secondes dans les mêmes conditions, le maximum de température mesuré sur l'un et/ou l'autre des substrats atteint une valeur voisine de 70°C.

La figure 5 montre une cartographie de température sur un substrat de silicium de diamètre égal à 300mm, après 15 secondes de chauffage local dans le cas où les picots sont attendus dans la partie haute du substrat en raison d'un collage initié dans la partie basse de ce substrat.

Le procédé de l'invention permet de réaliser un collage de meilleure qualité dans le cadre de la formation d'un SOI.

Dans le cas de la technologie Smart Cut™, ce procédé permet ainsi d'éviter les picots et les cloques simultanément (défauts macroscopiques souvent rédhibitoires) impliquant un gain en rendement et en qualité des structures obtenues.

Cette quasi-élimination des cloques et des picots concerne notamment des conditions favorisant l'apparition de cloques, c'est-à-dire lorsque une forte dose d'hydrogène est implantée (H seul) ou dans le cas d'une co-implantation d'hélium et d'hydrogène par exemple.

En effet, selon le procédé Smart Cut™, on vient former avant collage, une zone de fragilisation par implantation d'espèces atomiques ou ioniques dans l'épaisseur du substrat donneur, et on procède après collage, au détachement du substrat donneur au niveau de la zone de fragilisation de manière à transférer la couche mince sur un second substrat.

De manière classique, on co-implante de l'hélium et de l'hydrogène en décalant les pics d'implantation de ces deux espèces. On a en effet montré que l'on obtient de meilleurs résultats en termes de cloques en implantant l'hydrogène de telle sorte que son pic soit situé sensiblement à la profondeur du plan de détachement, tandis que l'hélium est implanté de telle sorte que son pic soit situé un peu plus profondément dans l'épaisseur du substrat donneur. Dans l'ensemble de ce texte, on définira ce pic comme étant la profondeur pour laquelle la concentration d'espèces implantées est maximale.

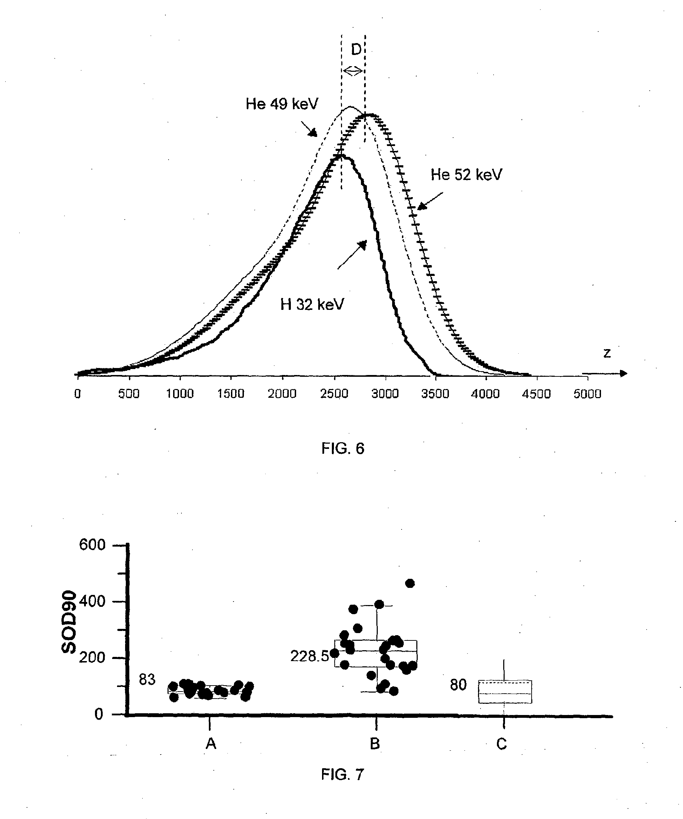

Par décalage, on entend une différence de profondeur au sein du substrat donneur. En référence à la figure 6, l'axe z est perpendiculaire à la surface du substrat donneur dans la direction de l'épaisseur croissante, l'origine étant à la surface du substrat du côté implanté. Le décalage entre les pics est représenté par la double flèche D.

En effet, lorsque l'on co-implante les atomes d'hélium et d'hydrogène avec des pics alignés à la même profondeur, on constate une formation importante de cloques à l'interface de collage. Au contraire, lorsque le pic d'implantation de l'hélium est décalé dans la profondeur du substrat donneur par rapport au pic d'implantation de l'hydrogène, on constate que l'on évite la formation des cloques. Cette problématique est exposée dans la demande de brevet US 2006/0060943.

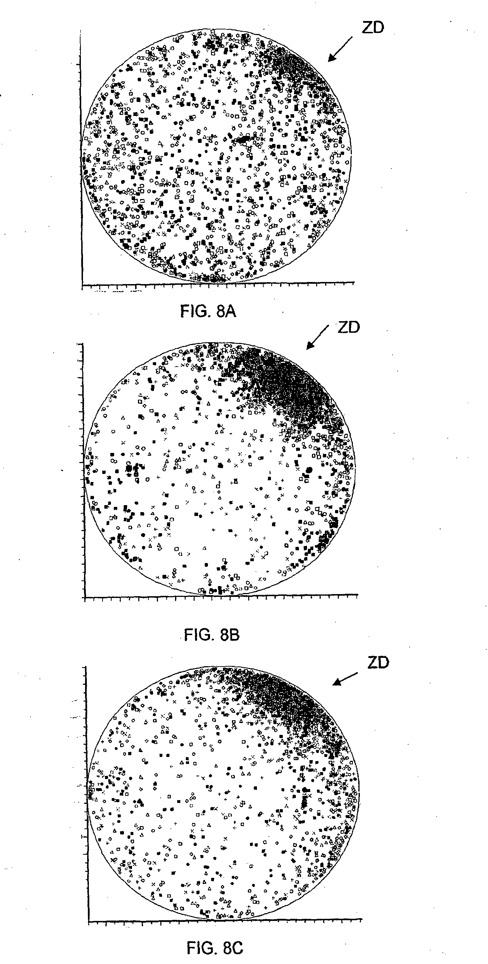

Par rugosité finale, on entend dans ce texte la présence d'une « zone dense » sur la plaque de SOI après le détachement selon la zone de fragilisation. La zone dense comprend des défauts peu profonds, non débouchants mais étendus. Elle n'apparaît pas sur toute la surface de la plaque mais est localisée dans la région de l'amorce du détachement, comme on peut le voir sur les figures 8A à 8C où la zone dense ZD est indiquée par une flèche.

La zone dense induit une rugosité « basse fréquence », mise en évidence notamment par AFM (microscopie à force atomique) sur des champs de taille 30x30µm², voire 40x40µm². Cette défectivité peut également être mesurée par le biais d'une mesure de « haze » effectuée au moyen d'un instrument de type Surfscan. Une valeur typique du seuil d'inspection sur un équipement Surfscan SP2 pour évaluer la zone dense est de 90 nm.

La rugosité de la zone dense d'une part limite le seuil d'inspection de la plaque et d'autre part signe une dégradation de la qualité de la surface. On cherche donc à limiter la formation de ce type de défaut.

Or, la Demanderesse a effectué des mesures sur la zone dense après l'application du procédé conforme à l'invention à une structure dans laquelle le substrat donneur a subi une co-implantation d'hélium et d'hydrogène avec le pic d'hélium décalé dans l'épaisseur du substrat donneur par rapport au pic d'hydrogène. Elle a constaté que le nettoyage au moyen d'un bain SC1 à basse température a un effet favorable sur la formation des cloques, mais défavorable sur l'étendue de la zone dense.

Par contre, la Demanderesse a constaté qu'en alignant les pics d'implantation de l'hydrogène et de l'hélium à une profondeur sensiblement identique dans l'épaisseur du substrat donneur et en effectuant un nettoyage à basse température conformément à l'invention, on limite la formation de cloques, et on réduit aussi la zone dense. La formation des picots est, quant à elle, limitée grâce au chauffage lors du collage. Par profondeur sensiblement identique, on entend une profondeur identique des deux pics ou un décalage en profondeur des pics d'hydrogène et d'hélium inférieur à 200Å.

Ainsi, la combinaison de l'alignement des pics d'hydrogène et d'hélium avec le nettoyage à basse température permet non seulement de prévenir la formation des cloques mais également de réduire la défectivité de la zone dense sur le SOI final.

De manière particulièrement avantageuse, on choisit l'énergie d'implantation de l'hydrogène en fonction de la profondeur d'implantation - et par conséquent de l'épaisseur de la couche mince à transférer - souhaitée. La détermination de cette énergie, qui dépend également du substrat à implanter, est à la portée de l'homme du métier.

On définit ensuite l'énergie d'implantation de l'hélium de manière à obtenir un pic d'hélium aligné sur celui de l'hydrogène, ou présentant par rapport au pic d'hydrogène un décalage inférieur à 200Å.

On remarque au passage, en référence à la figure 6, que les pics d'hydrogène et d'hélium ont des formes différentes : le pic d'hydrogène (H) est relativement étroit tandis que celui d'hélium (He) est plus large.

A titre d'exemple, en référence à la figure 6, dans un substrat donneur en silicium recouvert d'une couche d'oxyde de 1450 Å, on co-implante de l'hydrogène et de l'hélium, l'énergie de l'hydrogène étant choisie à 32 keV de manière à ce que le pic d'implantation soit à une profondeur de 2450 Å. Pour décaler les pics, comme dans la technique antérieure, on choisit une énergie d'implantation de l'hélium de l'ordre de 52 keV, ce qui induit un décalage des pics de l'ordre de 500 Å. La défectivité de la zone dense est typiquement supérieure à 200 défauts sur une tranche de diamètre 300 mm, ces défauts étant mesurés au seuil de 90 nm (cas B de la figure 7). Pour aligner les pics, on réduit l'énergie d'implantation de l'hélium à une valeur comprise entre 47 et 50 keV, de préférence 49 keV. La défectivité de la zone dense est alors de l'ordre de 80 défauts sur une tranche de diamètre 300 mm, toujours mesurée au seuil de 90 nm (cas A de la figure 7). A titre de comparaison, avec le procédé de l'état de la technique, c'est-à-dire un nettoyage à 65°C et un décalage des pics identique à celui du cas B, la défectivité de la zone dense est de l'ordre de 80 défauts (cas C de la figure 7).

On peut observer ces résultats sur les figures 8A à 8C.

La figure 8A montre la présence de la zone dense ZD sur une plaque de SOI ayant subi une co-implantation d'hydrogène et d'hélium avec les pics alignés (l'énergie d'implantation de l'hélium étant de 49 keV), et un nettoyage avant collage dans un bain SC1 à 55°C.

La figure 8B illustre la zone dense ZD sur une plaque ayant subi une co-implantation d'hélium et d'hydrogène avec des pics décalés (l'énergie d'implantation de l'hélium étant de 52 keV), et un nettoyage avant collage dans un bain SC1 à 55°C. Cette zone dense est beaucoup plus étendue que dans le cas précédent.

La figure 8C montre la zone dense sur une plaque ayant subi une co-implantation d'hélium et d'hydrogène avec des pics décalés (l'énergie d'implantation de l'hélium étant de 52 keV), et un nettoyage avant collage dans un bain SC1 à 65°C.

Ces figures montrent que l'alignement des pics d'implantation de l'hydrogène et de l'hélium permet de réduire sensiblement la défectivité liée à la zone dense compensant ici la dégradation observée lors de la diminution de la température du SC1 du nettoyage avant collage.

Revenant maintenant au procédé de collage conforme à l'invention, on relève qu'il permet également d'éviter le tri des substrats en amont du procédé. En effet, classiquement un tri était opéré, fondé sur les caractéristiques en bord des substrats à coller, c'est comme déjà mentionné, à cet endroit que les picots sont susceptibles d'apparaître. Ce tri conduisait à un important rejet de substrats.

Le fait d'utiliser des basses températures pour les bains du nettoyage RCA présente en outre un avantage économique, la durée de vie des bains est plus longue, puisque dans ces conditions il y a une faible évaporation des produits chimiques composant les bains. Ceci présente l'avantage de limiter les quantités de produits chimiques ajoutés pour stabiliser les concentrations des solutions en fonction du temps.

Surtout, ces conditions de nettoyages sont très proches voire identiques aux autres nettoyages qui interviennent dans le procédé Smart Cut™ (nettoyage après oxydation, après les traitements thermiques etc.).

Industriellement, il suffit donc d'un seul bain et potentiellement d'un seul équipement pour toutes les étapes du procédé.

On peut donc envisager d'optimiser le nettoyage et faire l'adaptation nécessaire sur l'étape de collage en modifiant les paramètres de durée et de température du collage.

En outre, le procédé de l'invention conduit à des substrats présentant une faible rugosité avant collage, d'où un collage plus fort et une interface de collage plus facile à stabiliser par la suite.

Le procédé selon l'invention permet enfin de s'affranchir du compromis picots/cloques rencontré en faisant varier la température du bain SC1 lors du nettoyage de l'un et/ou l'autre des substrats à coller.

Il apparaît par conséquent que les possibilités de réglage des paramètres du procédé sont simplifiées car on peut régler de façon indépendante les conditions de nettoyage pour minimiser l'apparition de cloques, et les conditions de collage permettant l'élimination des picots.

Ci-dessous sont donnés des résultats obtenus par l'utilisation du procédé de l'invention.

Dans le cas d'un collage Si / Si02 implanté pour réaliser un SOI par Smart Cut™, le substrat receveur Si est moins sensible au nettoyage (moins facilement gravé et/ou rugosifié). La rugosité typique d'un tel substrat receveur, mesurée par AFM sur des surfaces de 10x10µm², est inférieure ou égale à 1 Angström RMS. Le substrat donneur constitué de silicium oxydé en surface puis implanté par co-implantation d'hélium et d'hydrogène par exemple est quant à lui beaucoup plus facilement rugosifié et gravé par le nettoyage car il est fragilisé par l'implantation. Sa rugosité, voisine de 1,2-1,4 Angströms RMS avant le nettoyage, atteint environ 2 Angströms RMS après un nettoyage RCA avec un SC1 à une température de 75°C conduisant à une gravure de 30 Angströms. Par contre, si le même substrat donneur est soumis au même nettoyage à 40°C, sa rugosité reste inchangée, dans la gamme 1,2-1,4 Angströms RMS, et la gravure correspondante est proche de 5 Angströms. L'occurrence des cloques est alors environ quatre fois moindre après un nettoyage à 40°C, comparé au même nettoyage à 75°C.

Ci-dessous sont donnés des exemples de réalisation de structure sans cloques ni picots.

Dans ce premier exemple, le SOI est obtenu selon le procédé Smart Cut™ avec un chauffage local de courte durée :
- oxydation thermique et co-implantation d'hélium et d'hydrogène de concentrations de l'ordre de 1x10¹⁶ et 1x10¹⁶ at/cm² respectivement),
- nettoyage :
   - nettoyage des deux substrats au moyen d'un bain d'ozone suivi d'un rinçage,
   - nettoyage au moyen d'un bain SC1 à 40°C pendant trois minutes suivi d'un rinçage (dosage en pourcentage massique de 3% pour NH₄OH et 4% pour H₂O₂, le reste est de l'eau),
   - nettoyage au moyen d'un bain SC2 à 30°C pendant trois minutes suivi d'un rinçage (dosage en pourcentage massique de 0,7% pour HCl et 0.5% pour H₂O₂),
   - séchage,
- collage avec chauffage local de courte durée :
   - brossage ± rinçage des deux substrats avant collage,
   - séchage par centrifugation,
   - mise en regard des substrats à coller sur une station de collage,
   - mise en contact des substrats puis initiation du chauffage local par lampe halogène de puissance égale 500 Watts pendant 36 secondes,
   - initiation du collage lors du chauffage local, 20 secondes après le début de ce dernier,
- décollement et finition du SOI selon le procédé Smart Cut™.

Dans ce second exemple, la structure SOI est obtenue selon le procédé Smart Cut™ avec un chauffage local intermédiaire :
- oxydation thermique et implantation d'hydrogène à forte dose de l'ordre de 7x10¹⁶ at/cm².
- nettoyage :
- nettoyage au moyen d'un bain SC1 à 50°C pendant trois minutes suivi d'un rinçage,
- nettoyage au moyen d'un bain SC2 à 30°C pendant trois minutes suivi d'un rinçage,
   - séchage,
- activation du substrat donneur par plasma de O₂ pur,
- collage avec chauffage local intermédiaire :
   - brossage suivi d'un rinçage des substrats à coller avant collage,
   - séchage par centrifugation,
   - mise en regard des substrats à coller sur une station de collage,
- mise en contact des substrats puis initiation du chauffage local par lampe halogène 500 Watts pendant 50 secondes,
- initiation du collage lors du chauffage local, 35 secondes après le début de ce dernier,
- décollement et finition du SOI selon le procédé standard de Smart Cut™.

## Revendications

1. Procédé de collage de deux substrats entre eux au cours duquel on procède à la mise en contact des surfaces desdits substrats, comprenant au moins une étape de nettoyage de la surface de l'un et/ou l'autre des substrats à coller avant la mise en contact de leurs surfaces, le collage étant en outre précédé d'un chauffage d'au moins un substrat à coller, ledit chauffage étant initié avant la mise en contact des surfaces des substrats et prolongé au moins jusqu'à leur mise en contact,
où
- l'étape de nettoyage est réalisée de manière à ce que chaque surface nettoyée soit peu rugosifiée, c'est-à-dire avec une augmentation de la rugosité comprise entre 0 et 20 % ;
- l'étape de nettoyage de l'un et/ou l'autre des substrats à coller implique une gravure d'une épaisseur inférieure à 15 Angströms ;
**caractérisé en ce que** :
- le chauffage est appliqué localement au niveau d'une zone périphérique d'au moins un des deux substrats à coller ou est appliqué de manière uniforme sur l'étendue d'au moins un des deux substrats à coller, et est conduit à une température comprise entre 35°C et 90°C, typiquement entre 45°C et 70°C.

2. Procédé selon la revendication 1, **caractérisé en ce que** le chauffage se termine au plus tard à la fin de la propagation de l'onde de collage entre les deux substrats.

3. Procédé selon l'une des revendications précédentes, **caractérisé en ce que** l'étape de nettoyage est mise en oeuvre au moyen d'un bain à base de NH₄OH, H₂O₂, H₂O à une température inférieure à 65°C.

4. Procédé selon la revendication 3, **caractérisé en ce que** lors de l'étape de nettoyage le bain à base de NH₄OH, H₂O₂, H₂O est précédé d'un bain ozoné ou d'un bain d'acide sulfurique et d'eau oxygénée ou d'un nettoyage à base d'ozone sec et est suivi d'un bain à base de HCl, H₂O₂, H₂O.

5. Procédé selon l'une des revendications 3 ou 4, **caractérisé en ce que** le bain à base de NH₄OH, H₂O₂, H₂O :
- a un dosage en pourcentage massique en NH₄OH/H₂O₂ typiquement compris entre 1/2 et 6/6 et préférentiellement entre 1/2 et 3/4,
- est à une température comprise entre 5°C et 60°C, préférentiellement entre 40°C et 55°C,
- est appliqué pendant quelques minutes, préférentiellement trois minutes.

6. Procédé selon la revendication 4, **caractérisé en ce que** le bain à base de HCl, H₂O₂, H₂O :
- a un dosage en pourcentage massique de HCl compris entre 0,3% et 2%,
- a un dosage en pourcentage massique de H₂O₂ compris entre 0,3% et 2%,
- est à une température de 30°C,
- est appliqué pendant quelques minutes, préférentiellement trois minutes.

7. Procédé selon l'une des revendications 1 à 6, **caractérisé en ce que** le chauffage est obtenu par conduction thermique ou par rayonnement.

8. Procédé de formation d'une structure comprenant une couche mince en matériau semi-conducteur transférée d'un substrat donneur sur un second substrat, le procédé comprenant les étapes suivantes :
- co-implantation de deux espèces atomiques dans le substrat donneur de manière à créer une zone de fragilisation délimitant la couche mince à transférer, chacune des espèces présentant une concentration maximale à une profondeur dite « pic » ,
- nettoyage de la surface de l'un et/ou l'autre desdits substrats avant la mise en contact intime des surfaces des substrats à coller,
- mise en contact du second substrat avec le substrat donneur de manière à réaliser un collage desdits substrats entre eux,
- transfert d'une partie du substrat donneur vers le second substrat de manière à former ladite couche mince sur le second substrat,
**caractérisé en ce que** les deux espèces atomiques sont implantées de telle sorte que leurs pics présentent un décalage inférieur à 200 Å dans l'épaisseur du substrat donneur,
et **en ce que** le collage est réalisé par un procédé selon l'une des revendications 1 à 7.

9. Procédé selon la revendication 8, **caractérisé en ce que** les pics des deux espèces atomiques sont alignés à la même profondeur du substrat donneur.

10. Procédé selon l'une des revendications 8 ou 9, **caractérisé en ce que** les deux espèces atomiques sont de l'hydrogène et de l'hélium.

11. Procédé selon la revendication 10, **caractérisé en ce que** l'énergie d'implantation de l'hydrogène dans un substrat donneur de silicium recouvert d'une couche d'oxyde de 1450 Å est choisie à 32 keV de telle sorte que le pic d'implantation de l'hydrogène soit situé à une profondeur de 2450 Å dans le substrat donneur et **en ce que** l'énergie d'implantation de l'hélium est comprise entre 47 et 50 keV, de préférence égale à 49 keV.

## Claims

1. A method for adhesively bonding two substrates together during which it is proceeded with the putting of the surfaces of said substrates in contact with each other, comprising at least one step for cleaning the surface of one and/or the other of the substrates to be adhesively bonded before putting their surfaces into contact, the bonding being further preceded by heating at least one substrate to be adhesively bonded, said heating being initiated before putting the surfaces of the substrates into contact with each other and extended at least until they are put into contact with each other,
wherein
- the cleaning step is carried out so that each cleaned surface is not very roughened, i.e. with an increase in roughness comprised between 0 and 20%;
- the step for cleaning one and/or the other of the substrates to be adhesively bonded involves etching with a thickness of less than 15 angstroms;
**characterized in that**:
- the heating is applied locally at a peripheral area of at least one of the two substrates to be adhesively bonded or is applied uniformly over the extent of at least one of the two substrates to be bonded, and is conducted at a temperature comprised between 35°C and 90°C, typically between 45°C and 70°C.

2. The method according to claim 1, **characterized in that** the heating finishes at the latest at the end of the propagation of the bonding wave between both substrates.

3. The method according to one of the preceding claims, **characterized in that** the cleaning step is applied by means of a bath based on NH₄OH, H₂O₂, H₂O at a temperature of less than 65°C.

4. The method according to claim 3, characterized that during the cleaning step, the bath based on NH₄OH, H₂O₂ , H₂O is preceded with an ozoned bath or a bath of sulphuric acid and hydrogen peroxide or with cleaning based on dry ozone and is followed by a bath based on HCl, H₂O₂, H₂O.

5. The method according to one of claims 3 or 4, **characterized in that** the bath based on NH₄OH, H₂O₂, H₂O :
- has a mass percentage dosage of NH₄OH/H₂O₂ typically comprised between 1/2 and 6/6 and preferentially between 1/2 and 3/4,
- is at a temperature comprised between 5°C and 60°C, preferentially between 40°C and 55°C,
- is applied for a few minutes, preferentially three minutes.

6. The method according to claim 4, **characterized in that** the bath based on HCl, H₂O₂ , H₂O:
- has a mass percentage dosage of HCl comprised between 0.3% and 2%,
- has a mass percentage dosage of H₂O₂ comprised between 0.3% and 2%,
- is at a temperature of 30°C,
- is applied for a few minutes, preferentially three minutes.

7. The method according to one of claims 1 to 6, **characterized in that** the heating is obtained by heat conduction or by radiation.

8. A method for forming a structure comprising a thin layer in a semiconducting material transferred from a donor substrate onto a second substrate, the method comprising the following steps:
- co-implanting two atomic species in the donor substrate so as to create an embrittlement area delimiting the thin layer to be transferred, each of the species having a maximum concentration at a so-called "peak" depth,
- cleaning the surface of one and/or the other of said substrates before putting the surfaces of the substrate to be bonded in intimate contact,
- putting the second substrate into contact with the donor substrate so as to achieve adhesive bonding of said substrates together,
- transferring a portion of the donor substrate towards the second substrate so as to form said thin layer on the second substrate,
**characterized in that** both atomic species are implanted so that their peaks have a shift of less than 200 Å in the thickness of the donor substrate,
and **in that** the adhesive bonding is carried out by a method according to one of claims 1 to 7.

9. The method according to claim 8, **characterized in that** the peaks of both atomic species are aligned at the same depth of the donor substrate.

10. The method according to one of claims 8 or 9, **characterized in that** both atomic species are hydrogen and helium.

11. The method according to claim 10, **characterized in that** the implantation energy of hydrogen in a silicon donor substrate covered with a 1,450 Å oxide layer is selected to be 32 keV so that the implementation peak of hydrogen is located at a depth of 2,450 Å in the donor substrate and **in that** the implantation energy of helium is comprised between 47 and 50 keV, preferably equal to 49 keV.

## Patentansprüche

1. Verfahren zum Zusammenkleben von zwei Substraten, in dessen Verlauf die Oberflächen der Substrate in Kontakt gebracht werden, umfassend mindestens einen Schritt des Reinigens der Oberfläche des einen und/oder des anderen der zu klebenden Substrate vor dem In-Kontakt-Bringen ihrer Oberflächen, wobei dem Zusammenkleben darüber hinaus ein Erwärmen mindestens eines zu klebenden Substrats vorangeht, wobei man mit dem Erwärmen vor dem In-Kontakt-Bringen der Oberflächen der Substrate beginnt und dieses mindestens bis zu deren In-Kontakt-Bringen fortführt, wobei
- der Schritt der Reinigung auf solche Weise durchgeführt wird, dass jede gereinigte Oberfläche wenig aufgeraut ist, das heißt mit einer Vergrößerung der Rauheit zwischen 0 und 20 % einschließlich;
- der Schritt der Reinigung des einen und/oder des anderen der zu klebenden Substrate eine Ätzung mit einer Dicke unterhalb von 15 Angström mit sich bringt;
**dadurch gekennzeichnet, dass**:
- das Erwärmen lokal bei einer Umfangszone von mindestens einem der beiden zu klebenden Substrate angewendet wird oder auf gleichförmige Weise auf der Fläche mindestens eines der beiden zu klebenden Substrate angewendet wird und bei einer Temperatur zwischen 35 °C und 90 °C, typischerweise zwischen 45 °C und 70 °C einschließlich durchgeführt wird.

2. Verfahren nach Anspruch 1, **dadurch gekennzeichnet, dass** das Erwärmen spätestens am Ende der Fortpflanzung der Verklebungswelle zwischen den beiden Substraten beendet wird.

3. Verfahren nach einem der vorangehenden Ansprüche, **dadurch**
**gekennzeichnet, dass** der Schritt der Reinigung mittels eines Bades auf der Basis von NH₄OH, H₂O₂, H₂O bei einer Temperatur von unterhalb von 65 °C vorgenommen wird.

4. Verfahren nach Anspruch 3, **dadurch gekennzeichnet, dass** während des Schrittes der Reinigung dem Bad auf der Basis von NH₄OH, H₂O₂, H₂O ein Ozonbad oder ein Bad mit Schwefelsäure und sauerstoffhaltigem Wasser oder eine Reinigung auf der Basis von trockenem Ozon vorangeht und dass ihm ein Bad auf der Basis von HCl, H₂O₂, H₂O folgt.

5. Verfahren nach einem der Ansprüche 3 oder 4, **dadurch gekennzeichnet, dass** das Bad auf der Basis von NH₄OH, H₂O₂, H₂O:
- eine Dosierung als Massenprozentsatz an NH₄OH/H₂O₂ typischerweise zwischen 1/2 und 6/6 und vorzugsweise zwischen 1/2 und 3/4 einschließlich aufweist,
- sich bei einer Temperatur zwischen 5 °C und 60 °C, vorzugsweise zwischen 40 °C und 55 °C einschließlich befindet,
- während einiger Minuten, vorzugsweise drei Minuten, angewendet wird.

6. Verfahren nach Anspruch 4, **dadurch gekennzeichnet, dass** das Bad auf der Basis von HCl, H₂O₂, H₂O:
- eine Dosierung als Massenprozentsatz von HCl zwischen 0,3 % und 2 % einschließlich besitzt,
- eine Dosierung als Massenprozentsatz von H₂O₂ zwischen 0,3 % und 2 % einschließlich besitzt,
- sich bei einer Temperatur von 30 °C befindet,
- während einiger Minuten, vorzugsweise drei Minuten, angewendet wird.

7. Verfahren nach einem der Ansprüche 1 bis 6, **dadurch gekennzeichnet, dass** das Erwärmen durch Wärmeleitung oder durch Bestrahlung erhalten wird.

8. Verfahren zu Bildung einer Struktur, welche eine Dünnschicht an Halbleitermaterial umfasst, welche von einem Donorsubstrat auf ein zweites Substrat übertragen wird, wobei das Verfahren die folgenden Schritte umfasst:
- Co-Implantation von zwei Atomspezies in dem Donorsubstrat auf solche Weise, dass eine Schwächungszone geschaffen wird, welche die zu übertragende Dünnschicht eingrenzt, wobei jede der Spezies eine maximale Konzentration bei einer Tiefe aufweist, die als "Peak" bezeichnet wird,
- Reinigung der Oberfläche des einen und/oder des anderen der Substrate vor dem innigen In-Kontakt-Bringen der Oberflächen der zu verklebenden Substrate,
- In-Kontakt-Bringen des zweiten Substrats mit dem Donorsubstrat auf solche Weise, dass ein Zusammenkleben der Substrate bewirkt wird,
- Übertragung eines Teils des Donorsubstrats auf das zweite Substrat auf solche Weise, dass die Dünnschicht auf dem zweiten Substrat gebildet wird,
**dadurch gekennzeichnet, dass** die beiden Atomspezies so implantiert werden, dass ihre Peaks eine Verschiebung unterhalb von 200 Å in der Dicke des Donorsubstrats aufweisen,
und dadurch, dass das Kleben nach einem Verfahren gemäß einem der Ansprüche 1 bis 7 durchgeführt wird.

9. Verfahren nach Anspruch 8, **dadurch gekennzeichnet, dass** die Peaks der beiden Atomspezies bei der gleichen Tiefe des Donorsubstrats angeordnet sind.

10. Verfahren nach einem der Ansprüche 8 oder 9, **dadurch gekennzeichnet, dass** die beiden Atomspezies Wasserstoff und Helium sind.

11. Verfahren nach Anspruch 10, **dadurch gekennzeichnet, dass** die Implantationsenergie des Wasserstoffs in einem Silicium-Donorsubstrat, das mit einer Oxidschicht von 1450 Å bedeckt ist, zu 32 keV gewählt wird, derart, dass der Implantations-Peak des Wasserstoffs sich bei einer Tiefe von 2450 Å in dem Donorsubstrat befindet, und dadurch, dass die Implantationsenergie des Heliums zwischen 47 und 50 keV einschließlich beträgt, vorzugsweise gleich 49 keV ist.
